# EUROPEAN PATENT SPECIFICATION

(11) **EP 3 187 964 B1**
(45) Date of publication and mention of the grant of the patent: **11.04.2018**
(21) Application number: 16165274.8
(22) Date of filing: 14.04.2016
(51) Int. Cl.: H05K 7/20, G06F 1/20, H01L 23/427

(54) **HEAT DISSIPATION SYSTEM**
WÄRMEABSCHWÄCHUNGSSYSTEM
SYSTÈME DE DISSIPATION DE CHALEUR

(30) Priority: 30.12.2015 TW 104221183
(43) Date of publication of application: 05.07.2017
(73) Proprietor: MSI Computer (Shenzhen) Co., Ltd., Shenzhen City Guangdong Province, P.R.C. Guangdong (CN)
(72) Inventor: CHEN, Cheng-Lung, Taoyuan City, (TW); WU, Ching-Chi, Keelung City, (TW)
(74) Representative: Cabinet Plasseraud

(56) References cited:
- US-A- 6 137 683
- US-A1- 2010 328 878

## Description

### CROSS-REFERENCE TO RELATED APPLICATIONS

**This non-provisional application claims priority on Patent Application No(s).** 104221183 filed in Taiwan, R.O.C. on December 30th, 2015.

### Technical Field

The disclosure relates to a heat dissipation system, more particularly to a movable heat dissipation system.

### Background

Electronic products such as tablet computers or notebook computers have been developed to be more powerful because electronic components, such as high performance central processing unit (CPU) and high performance graphics processing unit (GPU), are provided therein. However, the high performance electronic components require more energy to operate, which generates a large amount of heat. If the heat is not removed, the performance of the electronic components will be degraded by overheating and thereby causing the electronic components to shutdown. Examples and embodiments of heat dissipation system of prior art may be found in US 2010/328878 A1.

There are two types of heat dissipation systems adaptive to cool dual heat sources: Independent heat dissipation system and thermally-bridged heat dissipation system. The independent heat dissipation system includes two heat dissipation modules for respectively cooling two heat sources, but the two heat dissipation modules are thermally isolated from each other. The thermally-bridged heat dissipation system includes two heat dissipation modules for respectively cooling two heat sources and further includes a heat pipe thermally connected the two heat dissipation modules. Thus, when one of the heat sources generates more heat, the exceeded heat transferred to one of the heat dissipation modules will be further transferred to the other heat dissipation module through the heat pipe. That is, the two heat dissipation modules can cool the two heat sources together through the heat pipe, which prevents single heat dissipation module from dealing too much heat in order to maintain the cooling efficiency. In addition, the heat pipe is fixed to the two heat dissipation modules by welding, thus the positions of the two heat dissipation modules as well as two heat absorbing surfaces thereon are fixed with respect to the heat pipe. Therefore, during the assembling of the electronic components, the electronic components (heat sources) should be assembled in specific steps in order to match the positions of the heat absorbing surfaces. In such a case, the traditional thermally-bridged heat dissipation system is only adaptive to few specific electronic products, which is narrow in application scope. Even if the electronic components are assembled in the specific steps, the electronic components may be tilted by the positional deviation. The absorbing surfaces of the heat dissipation system can not match the tilted electronic components, which results in poor thermal contact therebetween and thereby decreasing the cooling efficiency.

### SUMMARY

The present disclosure provides a heat dissipation system for solving the problems that the traditional heat dissipation system is in poor thermal contact with heat sources and is narrow in application scope. The main embodiment is detailed in the independent claim.

Additional embodiments are detailed in the dependent claims.

### BRIEF DESCRIPTION OF THE DRAWINGS

The present invention will become more fully understood from the detailed description given hereinbelow and the accompanying drawings which are given by way of illustration only and thus are not limitative of the present invention and wherein:
FIG. 1 is a perspective view of a heat dissipation system disposed in an electronic product according to a first embodiment of the disclosure;
FIG. 2 is a perspective view of the heat dissipation system in FIG. 1;
FIGS. 3A-3B are conceptual views showing the operation of the heat dissipation system in FIG. 1; and
FIG. 4 is a perspective view of a heat dissipation system according to a second embodiment of the disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

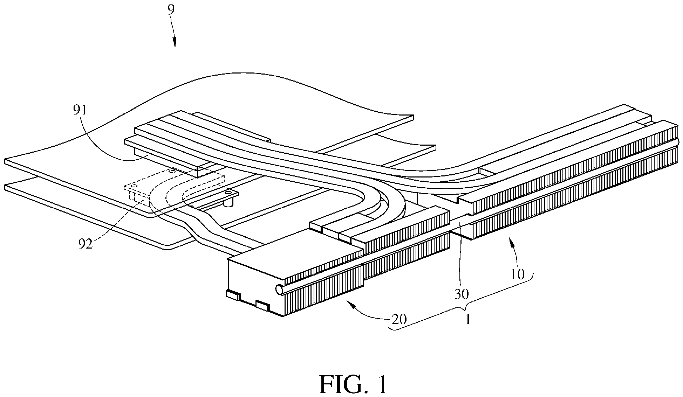

Please refer to FIG. 1, which is a perspective view of a heat dissipation system disposed in an electronic product according to a first embodiment of the disclosure. As shown in FIG. 1, a heat dissipation system 1 is provided. The heat dissipation system 1 is, for example, adaptive to an electronic product such as a tablet computer or a notebook computer. The heat dissipation system 1 is for removing heat generated by electronic components such as CPU and GPU disposed in the electronic product. As shown in FIG. 1, the heat dissipation system 1 is disposed in the electronic product 9 for removing heat generated by a first heat source 91 and a second heat source 92. In this embodiment, the first heat source 91 is a CPU, and the second heat source 92 is a GPU, but the present disclosure is not limited thereto. In other embodiments, the first heat source 91 may be the GPU, and the second heat source 92 may be the CPU.

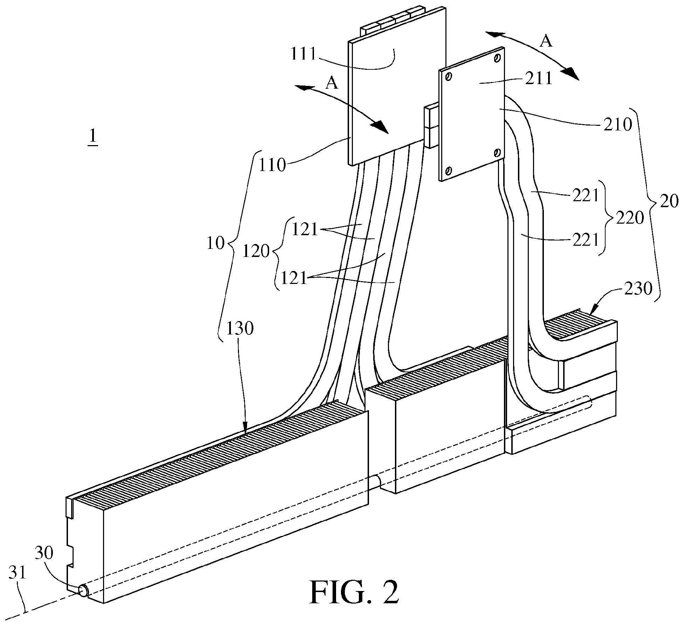

The heat dissipation system 1 will be described in below. Please refer to both FIG.1 and FIG. 2. FIG. 2 is a perspective view of the heat dissipation system in FIG. 1. In this embodiment, the heat dissipation system 1 includes a first heat dissipation module 10, a second heat dissipation module 20 and a bridge heat pipe 30. The first heat dissipation module 10 is for removing heat generated by the first heat source 91. The second heat dissipation module 20 is for removing heat generated by the second heat source 92. The bridge heat pipe 30 is in thermal contact with both of the first heat dissipation module 10 and the second heat dissipation module 20.

In detail, the first heat dissipation module 10 includes a first heat absorbing member 110, a first heat conducting member 120 and a first heat dissipating member 130. The first heat absorbing member 110 is made of high thermal conductivity materials such as iron, aluminum or iron-aluminum alloy. The first heat absorbing member 110 has a first heat absorbing surface 111 for being in thermal contact with the first heat source 91 and absorbing heat generated by the first heat source 91.

The first heat absorbing member 110 is in thermal contact with the first heat dissipating member 130 through the first heat conducting member 120. That is, the first heat conducting member 120 is in thermal contact with both the first heat absorbing member 110 and the first heat dissipating member 130. Specifically, in this embodiment, the first heat conducting member 120 is a heat pipe set having a plurality of heat pipes 121. One end of the heat pipe 121 is in thermal contact with the first heat absorbing member 110 by, for example, adhesion or welding. The first heat dissipating member 130 is a heat sink set having two heat sinks. The other end of the heat pipe 121 is in thermal contact with the heat sinks of the first heat dissipating member 130 by, for example, adhesion or welding. Specifically, in this embodiment, two of the heat pipes 121 are in thermal contact with one of the heat sinks of the first heat dissipating member 130, and the other two of the heat pipes 121 are in thermal contact with the other one of the heat sinks of the first heat dissipating member 130. Thus, heat absorbed by the first heat absorbing member 110 is able to be transferred to the first heat dissipating member 130 through the first heat conducting member 120 and then is dissipated by the first heat dissipating member 130. The present disclosure is not limited to the quantity of the heat pipes of the first heat conducting member 120 or the quantity of the heat sinks of the first heat dissipating member 130. In other embodiments, the first heat dissipating member 130 may be a heat sink, and the quantity of the heat pipe 121 may be one.

In addition, in this embodiment, the bridge heat pipe 30 is rotatably inserted into the first heat dissipating member 130, thus the first heat dissipation module 10 is able to be rotated relative to the bridge heat pipe 30 about a rotation axis 31. It is noted that the position of the bridge heat pipe 30 on the first heat dissipating member 130 can be altered according to actual requirement. For example, the bridge heat pipe 30 can be rotatably inserted into a front or side surface of the first heat dissipating member 130.

The second heat dissipation module 20 includes a second heat absorbing member 210, a second heat conducting member 220 and a second heat dissipating member 230. The second heat absorbing member 210 is made of high thermal conductivity materials such as iron, aluminum or iron-aluminum alloy. The second heat absorbing member 210 has a second heat absorbing surface 211 for being in thermal contact with the second heat source 92 and absorbing heat generated by the second heat source 92.

The second heat absorbing member 210 is in thermal contact with the second heat dissipating member 230 through the second heat conducting member 220. That is, the second heat conducting member 220 is in thermal contact with both of the second heat absorbing member 210 and the second heat dissipating member 230. Specifically, the second heat conducting member 220 is a heat pipe set having two heat pipes 221. One end of the heat pipe 221 is in thermal contact with the second heat absorbing member 210 by, for example, adhesion or welding. The second heat dissipating member 230 is a heat sink. The other end of the heat pipe 221 is in thermal contact with the heat sink of the second heat dissipating member 230 by, for example, adhesion or welding. Thus, heat absorbed by the second heat absorbing member 210 is able to be transferred to the second heat dissipating member 230 through the second heat conducting member 220 and then is dissipated by the second heat dissipating member 230. It is noted that the present disclosure is not limited to the quantity of the heat pipes 221 of the second heat conducting member 220 or the quantity of the heat sinks of the second heat dissipating member 230. In other embodiments, the first heat dissipating member 230 may be a heat sink set having a plurality of heat sinks, and the quantity of the heat pipe221 may be one.

In addition, in this embodiment, the bridge heat pipe 30 is rotatably inserted into the second heat dissipating member 230, thus the second heat dissipation module 20 is able to be rotated relative to the heat pipe 30 about the rotation axis 31. Similarly, the position of the bridge heat pipe 30 on the second heat dissipation module 20 can be altered as well.

Accordingly, in this embodiment, since the first heat dissipation module 10 and the second heat dissipation module 20 are able to be respectively rotated relative to the bridge heat pipe 30 in, for example, a direction of arrow A. Thus, an angle between the first heat absorbing surface 111 of the first heat dissipation module 10 and the second heat absorbing surface 211 of the second heat dissipation module 20 is able to be adjusted. Hence, the position of the first heat absorbing surface 111 of the first heat dissipation module 10 or the position of the second heat absorbing surface 211 of the second heat dissipation module 20 is able to be adjusted in order to respectively match the positions of the first heat source 91 and the second heat source 92.

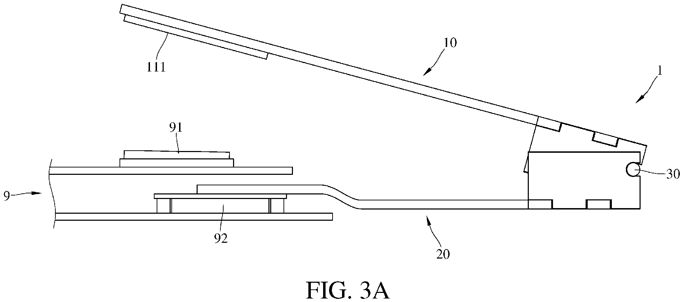

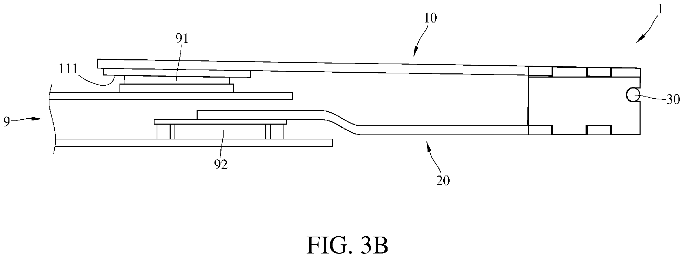

Then, please refer to FIGS. 3A-3B, which are conceptual views showing the operation of the heat dissipation system in FIG. 1. As shown in FIG. 3A, the electronic components (e.g. the heat source 91) may be tilted by the positional deviation during assembling. In such a case, the position of the first heat absorbing surface 111 is able to be adjusted in order to match the heat source 91 by rotating the first heat dissipation module 10, for ensuring sufficient thermal contact between the heat absorbing surface 111 and the heat source 91.

In addition, since the positions of the first heat absorbing surface 111 of the first heat dissipation module 10 and the second heat absorbing surface 211 of the second heat dissipation module 20 can be respectively matched with the positions of the first heat source 91 and the second heat source 92, the heat source 91 and the heat source 92 can be assembled ahead of positioning the heat absorbing surfaces. In other words, the heat absorbing surfaces can still be adjusted after the heat sources are assembled. Hence, the heat dissipation system 1 is wide in application scope compared to the traditional heat dissipation system.

Then, please refer back to FIG. 2, the first heat absorbing surface 111 of the first heat dissipation module 10 and the second heat absorbing surface 211 of the second heat dissipation module 20 are non-coplanar in order to match the positions of the heat sources, but the present disclosure is not limited thereto. In other embodiments, the first heat absorbing surface 111 of the first heat dissipation module 10 and the second heat absorbing surface 211 of the second heat dissipation module 20 are coplanar when the two modules are not rotated relative to the bridge heat pipe 30 yet.

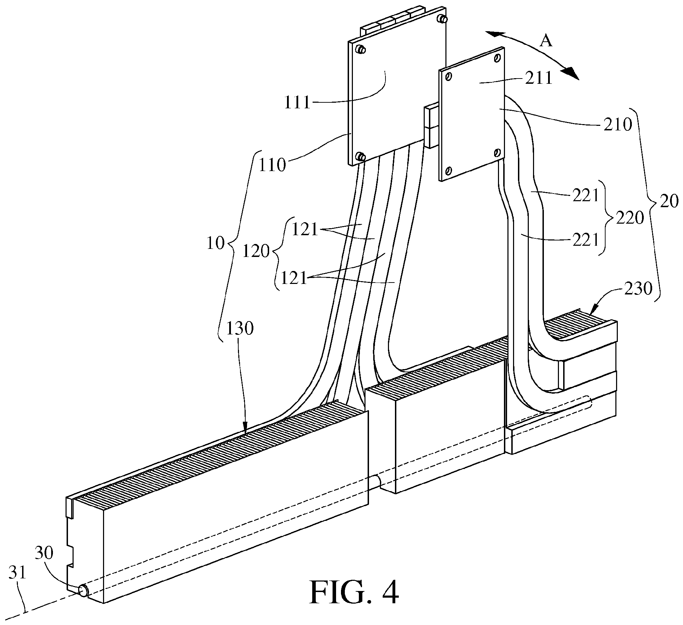

Furthermore, the present disclosure is not limited to that both of the first heat dissipation module 10 and the second heat dissipation module 20 are able to be rotated relative to the bridge heat pipe 30. For example, please refer to FIG. 4, which is a perspective view of a heat dissipation system according to a second embodiment of the disclosure. In this embodiment, the first heat dissipation module 10 and the bridge heat pipe 30 are fixed to each other. The second heat dissipation module 20 is pivoted to the bridge heat pipe 30, and the bridge heat pipe 30 is rotatably inserted into the heat dissipating member 230. Thus, only the second heat dissipation module 20 can be rotated relative to the bridge heat pipe 30 (e.g. in the direction of the arrow A). The angle between the second heat absorbing surface 211 of the second heat dissipation module 20 and the first heat absorbing surface 111 of the first heat dissipation module 10 can be adjusted by rotating the second heat dissipation module 20.

According to the heat dissipation system discussed above, both the first heat dissipation module and the second heat dissipation module can be rotated relative to the bridge heat pipe, thus an angle between the heat absorbing surface of the first heat dissipation module and the heat absorbing surface of the second heat dissipation module can be adjusted. Hence, the position of the heat absorbing surface of the first heat dissipation module or the position of the heat absorbing surface of the second heat dissipation module is able to be adjusted in order to respectively match with the positions of the heat sources, for ensuring good thermal contact between the heat absorbing surfaces and the heat sources.

In addition, since the positions of the heat absorbing surfaces can be respectively matched with the positions of the heat sources, during the assembling of the electronic components, some of the electronic components can be assembled in the electronic product ahead of positioning the heat absorbing surface. In other words, the heat absorbing surfaces can still be adjusted after the electronic components are assembled. Hence, the heat dissipation system of the present disclosure is wide in application scope.

## Claims

1. A heat dissipation system (1), comprising:
a first heat dissipation module (10) having a heat absorbing surface (111) for being in thermal contact with a first heat source (91);
a second heat dissipation module (20) having a heat absorbing surface (211) for being in thermal contact with a second heat source (92); and
a bridge heat pipe (30), the first heat dissipation module (10) disposed on the bridge heat pipe (30), the second heat dissipation module (20) pivoted to the bridge heat pipe (30) for adjusting an angle between the heat absorbing surface (111) of the first heat dissipation module (10) and the heat absorbing surface (211) of the second heat dissipation module (20); wherein:
the first heat dissipation module (10) comprises a first heat absorbing member (110), a first heat conducting member (120) and a first heat dissipating member (130), the first heat absorbing surface (111) is located on the heat absorbing member (110) of the first heat dissipation module (10), the first heat absorbing member (110) is in thermal contact with the first heat dissipating member (130) through the first heat conducting member (120), the second heat dissipation module (20) comprises a second heat absorbing member (210), a second heat conducting member (220) and a second heat dissipating member (230), the heat absorbing surface (211) of the second heat dissipation module (20) is on the second heat absorbing member (210), the second heat absorbing member (210) is in thermal contact with the second heat dissipating member (230) through the second heat conducting member (220), and the bridge heat pipe (30) is rotatably inserted into the second heat dissipating member (230) and connected to the first heat dissipating member (130) so that the second heat dissipating member (230) and the first heat dissipating member (130) are rotatable with respect to each other in order to adjust the angle between the heat absorbing surface (111) of the first heat dissipation module (10) and the heat absorbing surface (211) of the second heat dissipation module (20).

2. The heat dissipation system according to claim 1, wherein the second heat dissipation module (20) is rotatable relative to the bridge heat pipe (30) about an axis (31) of the bridge heat pipe (30).

3. The heat dissipation system according to claim 1, wherein the first heat dissipation module (10) is pivoted to the bridge heat pipe (30).

4. The heat dissipation system according to claim 1, wherein the first heat dissipation module (10) is fixed to the bridge heat pipe (30).

5. The heat dissipation system according to claim 3, wherein the first heat dissipation module (10) and the second heat dissipation module (20) are rotatable rotated relative to the bridge heat pipe (30) about an axis (31) of the bridge heat pipe (30).

6. The heat dissipation system according to claim 1, wherein the first heat dissipation module (10) comprises a heat absorbing member (110), a heat conducting member (120) and a heat dissipating member (130), the heat absorbing surface (111) of the first heat dissipation module (10) is located on the heat absorbing member (110) of the first heat dissipation module (10), the heat absorbing member (110) of the first heat dissipation module (10) is in thermal contact with the heat dissipating member (130) of the first heat dissipation module (10) through the heat conducting member (120) of the first heat dissipation module (10), and the bridge heat pipe (30) is rotatably inserted into the heat dissipating member (130) of the first heat dissipation module (10).

7. The heat dissipation system according to claim 6, wherein the heat absorbing member (110) of the first heat dissipation module (10) is made of iron, aluminum or iron-aluminum alloy.

8. The heat dissipation system according to claim 6, wherein the heat dissipating member (130) of the first heat dissipation module (10) is a heat sink.

9. The heat dissipation system according to claim 1, wherein the second heat dissipation module (20) comprises an heat absorbing member (210), a heat conducting member (220) and a heat dissipating member (230), the heat absorbing surface (211) of the second heat dissipation module (20) is on the heat absorbing member (210) of the second heat dissipation module (20), the heat absorbing member (210) of the second heat dissipation module (20) is in thermal contact with the heat dissipating member (230) of the second heat dissipation module (20) through the heat conducting member (220) of the second heat dissipation module (20), and the bridge heat pipe (30) is rotatably inserted into the heat dissipating member (230) of the second heat dissipation module (20).

10. The heat dissipation system according to claim 9, wherein the heat absorbing member (201) of the second heat dissipation module (20) is made of iron, aluminum or iron-aluminum alloy.

11. The heat dissipation system according to claim 9, wherein the heat dissipating member (230) of the second heat dissipation module (20) is a heat sink.

12. The heat dissipation system according to claim 1, wherein the heat absorbing surface (111) of the first heat dissipation module (10) and the heat absorbing surface (211) of the second heat dissipation module (20) are non-coplanar.

## Patentansprüche

1. Wärmeabführungssystem (1), aufweisend:
ein erstes Wärmeabführungsmodul (10) mit einer wärmeabsorbierenden Oberfläche (111) in thermischem Kontakt mit einer ersten Wärmequelle (91);
ein zweites Wärmeabführungsmodul (20) mit einer wärmeabsorbierenden Oberfläche (211) in thermischem Kontakt mit einer zweiten Wärmequelle (92); und
ein Brückenwärmerohr (30), wobei das erste Wärmeabführungsmodul (10) an dem Brückenwärmerohr (30) angeordnet ist, das zweite Wärmeabführungsmodul (20) drehbar an dem Brückenwärmerohr (30) gelagert ist, um einen Winkel zwischen der wärmeabsorbierenden Oberfläche (111) des ersten Wärmeabführungsmoduls (10) und der wärmeabsorbierenden Oberfläche (211) des zweiten Wärmeabführungsmoduls (20) anzupassen;
wobei:
das erste Wärmeabführungsmodul (10) ein erstes wärmeabsorbierendes Element (110), ein erstes wärmeleitendes Element (120) und ein erstes wärmeabführendes Element (130) aufweist, die erste wärmeabsorbierende Oberfläche (111) sich an dem wärmeabsorbierenden Element (110) des ersten Wärmeabführungsmoduls (10) befindet, das erste wärmeabsorbierende Element (110) über das erste wärmeleitende Element (120) in thermischem Kontakt mit dem ersten wärmeabführenden Element (130) ist, das zweite Wärmeabführungsmodul (20) ein zweites wärmeabsorbierendes Element (210), ein zweites wärmeleitendes Element (220) und ein zweites wärmeabführendes Element (230) aufweist, die wärmeabsorbierende Oberfläche (211) des zweiten Wärmeabführungsmoduls (20) an dem zweiten wärmeabsorbierenden Element (210) ist, das zweite wärmeabsorbierende Element (210) über das zweite wärmeleitende Element (220) in thermischem Kontakt mit dem zweiten wärmeabführenden Element (230) ist, und das Brückenwärmerohr (30) drehbar in das zweite wärmabführende Element (230) eingesetzt ist und mit dem ersten wärmeabführenden Element (130) verbunden ist, so dass das zweite wärmeabführende Element (230) und das erste wärmeabführende Element (130) relativ zueinander drehbar sind, um den Winkel zwischen der wärmeabsorbierenden Oberfläche (111) des ersten Wärmeabführungsmoduls (10) und der wärmeabsorbierenden Oberfläche (211) des zweiten Wärmeabführungsmoduls (20) anzupassen.

2. Wärmeabführungssystem nach Anspruch 1, wobei das zweite Wärmeabführungsmodul (20) um eine Achse (31) des Brückenwärmerohrs (30) relativ zu dem Brückenwärmerohr (30) drehbar ist.

3. Wärmeabführungssystem nach Anspruch 1, wobei das erste Wärmeabführungsmodul (10) drehbar an dem Brückenwärmerohr (30) gelagert ist.

4. Wärmeabführungssystem nach Anspruch 1, wobei das erste Wärmeabführungsmodul (10) fest an dem Brückenwärmerohr (30) angebracht ist.

5. Wärmeabführungssystem nach Anspruch 3, wobei das erste Wärmeabführungsmodul (10) und das zweite Wärmeabführungsmodul (20) um eine Achse (31) des Brückenwärmerohrs (30) relativ zu dem Brückenwärmerohr (30) drehbar gedreht sind.

6. Wärmeabführungssystem nach Anspruch 1, wobei das erste Wärmeabführungsmodul (10) ein wärmeabsorbierendes Element (110), ein wärmeleitendes Element (120) und ein wärmeabführendes Element (130) aufweist, die wärmeabsorbierende Oberfläche (111) des ersten Wärmeabführungsmoduls (10) sich an dem wärmeabsorbierenden Element (110) des ersten Wärmeabführungsmoduls (10) befindet, das wärmeabsorbierende Element (110) des ersten Wärmeabführungsmoduls (10) über das wärmeleitende Element (120) des ersten Wärmeabführungsmoduls (10) in thermischem Kontakt mit dem wärmeabführenden Element (130) des ersten Wärmeabführungsmoduls (10) ist, und das Brückenwärmerohr (30) drehbar in das wärmeabführende Element (130) des ersten Wärmeabführungsmoduls (10) eingesetzt ist.

7. Wärmeabführungssystem nach Anspruch 6, wobei das wärmeabsorbierende Element (110) des ersten Wärmeabführungsmoduls (10) aus Eisen, Aluminium oder einer Eisen-Aluminium-Legierung hergestellt ist.

8. Wärmeabführungssystem nach Anspruch 6, wobei das wärmeabführende Element (130) des ersten Wärmeabführungsmoduls (10) eine Wärmesenke ist.

9. Wärmeabführungssystem nach Anspruch 1, wobei das zweite Wärmeabführungsmodul (20) ein wärmeabsorbierendes Element (210), ein wärmeleitendes Element (220) und ein wärmeabführendes Element (230) aufweist, die wärmeabsorbierende Oberfläche (211) des zweiten Wärmeabführungsmoduls (20) sich an dem wärmeabsorbierenden Element (210) des zweiten Wärmeabführungsmoduls (20) befindet, das wärmeabsorbierende Element (210) des zweiten Wärmeabführungsmoduls (20) über das wärmeleitende Element (220) des zweiten Wärmeabführungsmoduls (20) in thermischem Kontakt mit dem wärmeabführenden Element (230) des zweiten Wärmeabführungsmoduls (20) ist, und das Brückenwärmerohr (30) drehbar in das wärmeabführende Element (230) des zweiten Wärmeabführungsmoduls (20) eingesetzt ist.

10. Wärmeabführungssystem nach Anspruch 9, wobei das wärmeabsorbierende Element (210) des zweiten Wärmeabführungsmoduls (20) aus Eisen, Aluminium oder einer Eisen-Aluminium-Legierung hergestellt ist.

11. Wärmeabführungssystem nach Anspruch 9, wobei das wärmeabführende Element (230) des zweiten Wärmeabführungsmoduls (20) eine Wärmesenke ist.

12. Wärmeabführungssystem nach Anspruch 1, wobei die wärmeabsorbierende Oberfläche (111) des ersten Wärmeabführungsmoduls (10) und die wärmeabsorbierende Oberfläche (211) des zweiten Wärmeabführungsmoduls (20) nicht komplanar sind.

## Revendications

1. Système de dissipation de chaleur (1), comprenant :
un premier module de dissipation de chaleur (10) ayant une surface d'absorption de chaleur (111) pour être en contact thermique avec une première source de chaleur (91) ;
un second module de dissipation de chaleur (20) ayant une surface d'absorption de chaleur (211) pour être en contact thermique avec une seconde source de chaleur (92) ; et
un caloduc en pont (30), le premier module de dissipation de chaleur (10) étant disposé sur le caloduc en pont (30), le second module de dissipation de chaleur (20) pivotant sur le caloduc en pont (30) pour régler un angle entre la surface d'absorption de chaleur (111) du premier module de dissipation de chaleur (10) et la surface d'absorption de chaleur (211) du second module de dissipation de chaleur (20) ;
dans lequel :
le premier module de dissipation de chaleur (10) comprend un premier organe d'absorption de chaleur (110), un premier organe de conduction de chaleur (120) et un premier organe de dissipation de chaleur (130), la première surface d'absorption de chaleur (111) est située sur l'organe d'absorption de chaleur (110) du premier module de dissipation de chaleur (10), le premier organe d'absorption de chaleur (110) est en contact thermique avec le premier organe de dissipation de chaleur (130) par l'intermédiaire du premier organe de conduction de chaleur (120), le second module de dissipation de chaleur (20) comprend un second organe d'absorption de chaleur (210), un second organe de conduction de chaleur (220) et un second organe de dissipation de chaleur (230), la surface d'absorption de chaleur (211) du second module de dissipation de chaleur (20) est sur le second organe d'absorption de chaleur (210), le second organe d'absorption de chaleur (210) est en contact thermique avec le second organe de dissipation de chaleur (230) par l'intermédiaire du second organe de conduction de chaleur (220), et le caloduc en pont (30) est inséré en rotation dans le second organe de dissipation de chaleur (230) et raccordé au premier organe de dissipation de chaleur (130) de sorte que le second organe de dissipation de chaleur (230) et le premier organe de dissipation de chaleur (130) soient rotatifs l'un par rapport à l'autre afin de régler l'angle entre la surface d'absorption de chaleur (111) du premier module de dissipation de chaleur (10) et la surface d'absorption de chaleur (211) du second module de dissipation de chaleur (20).

2. Système de dissipation de chaleur selon la revendication 1, dans lequel le second module de dissipation de chaleur (20) est rotatif par rapport au caloduc en pont (30) autour d'un axe (31) du caloduc en pont (30).

3. Système de dissipation de chaleur selon la revendication 1, dans lequel le premier module de dissipation de chaleur (10) pivote sur le caloduc en pont (30).

4. Système de dissipation de chaleur selon la revendication 1, dans lequel le premier module de dissipation de chaleur (10) est fixé sur le caloduc en pont (30).

5. Système de dissipation de chaleur selon la revendication 3, dans lequel le premier module de dissipation de chaleur (10) et le second module de dissipation de chaleur (20) sont tournés en rotation par rapport au caloduc en pont (30) autour d'un axe (31) du caloduc en pont (30).

6. Système de dissipation de chaleur selon la revendication 1, dans lequel le premier module de dissipation de chaleur (10) comprend un organe d'absorption de chaleur (110), un organe de conduction de chaleur (120) et un organe de dissipation de chaleur (130), la surface d'absorption de chaleur (111) du premier module de dissipation de chaleur (10) est située sur l'organe d'absorption de chaleur (110) du premier module de dissipation de chaleur (10), l'organe d'absorption de chaleur (110) du premier module de dissipation de chaleur (10) est en contact thermique avec l'organe de dissipation de chaleur (130) du premier module de dissipation de chaleur (10) par l'intermédiaire de l'organe de conduction de chaleur (120) du premier module de dissipation de chaleur (10), et le caloduc en pont (30) est inséré en rotation dans l'organe de dissipation de chaleur (130) du premier module de dissipation de chaleur (10).

7. Système de dissipation de chaleur selon la revendication 6, dans lequel l'organe d'absorption de chaleur (110) du premier module de dissipation de chaleur (10) est réalisé en fer, en aluminium ou en alliage de fer-aluminium.

8. Système de dissipation de chaleur selon la revendication 6, dans lequel l'organe de dissipation de chaleur (130) du premier module de dissipation de chaleur (10) est un dissipateur thermique.

9. Système de dissipation de chaleur selon la revendication 1, dans lequel le second module de dissipation de chaleur (20) comprend un organe d'absorption de chaleur (210), un organe de conduction de chaleur (220) et un organe de dissipation de chaleur (230), la surface d'absorption de chaleur (211) du second module de dissipation de chaleur (20) est sur l'organe d'absorption de chaleur (210) du second module de dissipation de chaleur (20), l'organe d'absorption de chaleur (210) du second module de dissipation de chaleur (20) est en contact thermique avec l'organe de dissipation de chaleur (230) du second module de dissipation de chaleur (20) par l'intermédiaire de l'organe de conduction de chaleur (220) du second module de dissipation de chaleur (20), et le caloduc en pont (30) est inséré en rotation dans l'organe de dissipation de chaleur (230) du second module de dissipation de chaleur (20).

10. Système de dissipation de chaleur selon la revendication 9, dans lequel l'organe d'absorption de chaleur (201) du second module de dissipation de chaleur (20) est réalisé en fer, en aluminium ou en alliage de fer-aluminium.

11. Système de dissipation de chaleur selon la revendication 9, dans lequel l'organe de dissipation de chaleur (230) du second module de dissipation de chaleur (20) est un dissipateur thermique.

12. Système de dissipation de chaleur selon la revendication 1, dans lequel la surface d'absorption de chaleur (111) du premier module de dissipation de chaleur (10) et la surface d'absorption de chaleur (211) du second module de dissipation de chaleur (20) sont non coplanaires.
